# FASCICULE DE BREVET EUROPEEN

(11) **EP 3 859 793 B1**
(45) Date de publication et mention de la délivrance du brevet: **10.05.2023**
(21) Numéro de dépôt: 21153274.2
(22) Date de dépôt: 25.01.2021
(51) Int. Cl.: H01L 31/048, H01L 31/049

(54) **MODULE PHOTOVOLTAÏQUE LÉGER COMPORTANT UNE COUCHE AVANT ET UNE COUCHE ARRIÈRE EN MATÉRIAUX COMPOSITES**
LEICHTES FOTOVOLTAIKMODUL MIT EINER VORDEREN UND EINER HINTEREN SCHICHT AUS VERBUNDMATERIALIEN
LIGHT PHOTOVOLTAIC MODULE COMPRISING A FRONT LAYER AND A REAR LAYER MADE OF COMPOSITE MATERIALS

(30) Priorité: 27.01.2020 FR 2000759
(43) Date de publication de la demande: 04.08.2021
(73) Titulaire: Commissariat à l'énergie atomique et aux énergies alternatives, 75015 Paris (FR)
(72) Inventeur: GAUME, Julien, 38054 GRENOBLE CEDEX 09 (FR); GUILLEREZ, Stéphane, 38054 GRENOBLE CEDEX 09 (FR); VESCHETTI, Yannick, 38054 GRENOBLE CEDEX 09 (FR)
(74) Mandataire: Brevalex

(56) Documents cités:
- EP-A1- 3 244 456
- WO-A1-2017/212194
- WO-A1-2019/184242
- WO-A1-2019/224458
- FR-A1- 3 024 285

## Description

### DOMAINE TECHNIQUE

La présente invention se rapporte au domaine des modules photovoltaïques, qui comportent un ensemble de cellules photovoltaïques reliées entre elles électriquement, et préférentiellement des cellules photovoltaïques dites « cristallines », c'est-à-dire qui sont à base de silicium monocristallin ou multicristallin.

L'invention peut être mise en oeuvre pour de nombreuses applications, notamment civiles et/ou militaires, par exemple des applications autonomes et/ou embarquées, étant particulièrement concernée par les applications qui requièrent l'utilisation de modules photovoltaïques sans verre et légers, en particulier d'un poids par unité de surface inférieur à 5 kg/m², et de faible épaisseur, notamment inférieure à 5 mm. Elle peut ainsi notamment être appliquée pour des bâtiments tels que des habitats ou locaux industriels (tertiaires, commerciaux, ...), par exemple pour la réalisation de leurs toitures, pour la conception de mobilier urbain, par exemple pour de l'éclairage public, la signalisation routière ou encore la recharge de voitures électriques, voire également être utilisée pour des applications nomades (mobilité solaire), en particulier pour une intégration sur des véhicules, tels que voitures, bus ou bateaux, des drones, des ballons dirigeables, entre autres.

L'invention propose ainsi un module photovoltaïque léger comportant une première couche formant la face avant du module, comprenant une première couche composite, et une deuxième couche formant la face arrière du module, comprenant une deuxième couche composite, ainsi qu'un procédé de réalisation d'un tel module photovoltaïque.

### ÉTAT DE LA TECHNIQUE ANTÉRIEURE

Un module photovoltaïque est un assemblage de cellules photovoltaïques disposées côte à côte entre une première couche transparente formant une face avant du module photovoltaïque et une seconde couche formant une face arrière du module photovoltaïque.

La première couche formant la face avant du module photovoltaïque est avantageusement transparente pour permettre aux cellules photovoltaïques de recevoir un flux lumineux. Elle est traditionnellement réalisée en une seule plaque de verre, notamment du verre trempé, présentant une épaisseur typiquement comprise entre 2 et 4 mm, classiquement de l'ordre de 3 mm.

La deuxième couche formant la face arrière du module photovoltaïque peut quant à elle être réalisée à base de verre, de métal ou de plastique, entre autres. Elle est souvent formée par une structure polymérique à base d'un polymère isolant électrique, par exemple du type polytéréphtalate d'éthylène (PET) ou polyamide (PA), pouvant être protégée par une ou des couches à base de polymères fluorés, comme le polyfluorure de vinyle (PVF) ou le polyfluorure de vinylidène (PVDF), et ayant une épaisseur de l'ordre de 400 µm.

Les cellules photovoltaïques peuvent être reliées électriquement entre elles par des éléments de contact électrique avant et arrière, appelés conducteurs de liaison, et formés par exemple par des bandes de cuivre étamé, respectivement disposées contre les faces avant (faces se trouvant en regard de la face avant du module photovoltaïque destinée à recevoir un flux lumineux) et arrière (faces se trouvant en regard de la face arrière du module photovoltaïque) de chacune des cellules photovoltaïques, ou bien encore uniquement en face arrière pour les cellules photovoltaïques de type IBC (pour « Interdigitated Back Contact » en anglais).

Il est à noter que les cellules photovoltaïques de type IBC (« Interdigitated Back Contact ») sont des structures pour lesquelles les contacts sont réalisés sur la face arrière de la cellule en forme de peignes interdigités. Elles sont par exemple décrites dans le brevet américain US 4,478,879 A.

Par ailleurs, les cellules photovoltaïques, situées entre les première et deuxième couches formant respectivement les faces avant et arrière du module photovoltaïque, peuvent être encapsulées. De façon classique, l'encapsulant choisi correspond à un polymère du type élastomère (ou caoutchouc), et peut par exemple consister en l'utilisation de deux couches (ou films) de poly(éthylène-acétate de vinyle) (EVA) entre lesquelles sont disposées les cellules photovoltaïques et les conducteurs de liaison des cellules. Chaque couche d'encapsulant peut présenter une épaisseur d'au moins 0,2 mm et un module de Young typiquement compris entre 2 et 400 MPa à température ambiante.

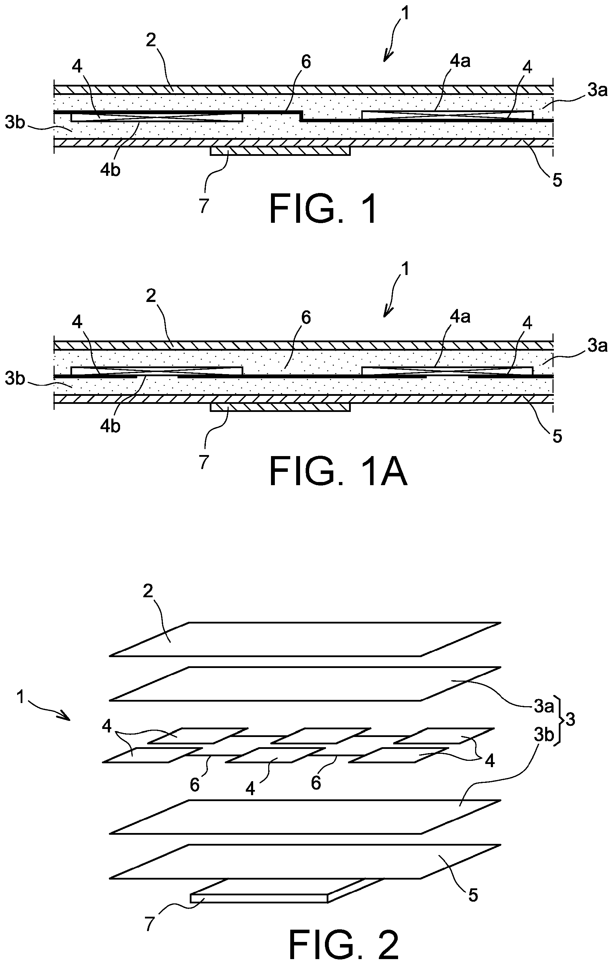

On a ainsi représenté partiellement et schématiquement, respectivement en coupe sur la figure 1 et en vue éclatée sur la figure 2, un exemple classique de module photovoltaïque 1 comportant des cellules photovoltaïques 4 cristallines.

Comme décrit précédemment, le module photovoltaïque 1 comporte une face avant 2, généralement réalisée en verre trempé transparent d'épaisseur d'environ 3 mm, et une face arrière 5, par exemple constituée par une feuille polymère, opaque ou transparente, monocouche ou multicouche, ayant un module de Young supérieur à 400 MPa à température ambiante.

Entre les faces avant 2 et arrière 5 du module photovoltaïque 1 se situent les cellules photovoltaïques 4, reliées électriquement entre elles par des conducteurs de liaison 6 et immergées entre deux couches avant 3a et arrière 3b de matériau d'encapsulation formant toutes les deux un ensemble encapsulant 3.

La figure 1A représente en outre une variante de réalisation de l'exemple de la figure 1 dans laquelle les cellules photovoltaïques 4 sont de type IBC, les conducteurs de liaison 6 étant uniquement disposés contre les faces arrières des cellules photovoltaïques 4.

Par ailleurs, les figures 1 et 2 représentent également la boîte de jonction 7 du module photovoltaïque 1, destinée à recevoir le câblage nécessaire à l'exploitation du module. Classiquement, cette boîte de jonction 7 est réalisée en plastique ou en caoutchouc, et présente une étanchéité complète.

De façon habituelle, le procédé de réalisation du module photovoltaïque 1 comporte une étape dite de lamination sous vide des différentes couches décrites précédemment, à une température supérieure ou égale à 120°C, voire 140°C, voire encore 150°C, et inférieure ou égale à 170°C, typiquement comprise entre 145 et 165°C, et pendant une durée du cycle de lamination d'au moins 10 minutes, voire 15 minutes.

Pendant cette étape de lamination, les couches de matériau d'encapsulation 3a et 3b fondent et viennent englober les cellules photovoltaïques 4, en même temps que l'adhérence se crée à toutes les interfaces entre les couches, à savoir entre la face avant 2 et la couche avant de matériau d'encapsulation 3a, la couche de matériau d'encapsulation 3a et les faces avant 4a des cellules photovoltaïques 4, les faces arrière 4b des cellules photovoltaïques 4 et la couche arrière de matériau d'encapsulation 3b, et la couche arrière de matériau d'encapsulation 3b et la face arrière 5 du module photovoltaïque 1. Le module photovoltaïque 1 obtenu est ensuite encadré, typiquement par le biais d'un profilé en aluminium.

Une telle structure est maintenant devenue un standard qui possède une résistance mécanique importante grâce à l'utilisation d'une face avant 2 en verre épais et du cadre aluminium, lui permettant, notamment et dans la majorité des cas, de respecter les normes IEC 61215 et IEC 61730.

Néanmoins, un tel module photovoltaïque 1 selon la conception classique de l'art antérieur présente l'inconvénient d'avoir un poids élevé, en particulier un poids par unité de surface supérieur à 10 kg/m², voire 12 kg/m², et n'est ainsi pas adapté pour certaines applications pour lesquelles la légèreté est une priorité.

Ce poids élevé du module photovoltaïque 1 provient principalement de la présence du verre épais, avec une épaisseur d'environ 3 mm, pour former la face avant 2, la densité du verre étant en effet élevée, de l'ordre de 2,5 kg/m²/mm d'épaisseur, et du cadre aluminium. Pour pouvoir résister aux contraintes lors de la fabrication et également pour des raisons de sécurité, par exemple du fait du risque de coupure, le verre est trempé. Or, l'infrastructure industrielle de la trempe thermique est configurée pour traiter du verre d'au moins 3 mm d'épaisseur. En outre, le choix d'avoir une épaisseur de verre d'environ 3 mm est également lié à une résistance mécanique à la pression normée de 5,4 kPa. En définitif, le verre représente ainsi à lui seul pratiquement 70 % du poids du module photovoltaïque 1, et plus de 80 % avec le cadre en aluminium autour du module photovoltaïque 1.

Aussi, afin d'obtenir une réduction significative du poids d'un module photovoltaïque pour permettre son utilisation dans de nouvelles applications exigeantes en termes de légèreté et de mise en forme, il existe un besoin pour trouver une solution alternative à l'utilisation d'un verre épais en face avant du module. Une des problématiques consiste donc à remplacer la face avant en verre par de nouveaux matériaux plastiques ou composites tout en conservant l'architecture et la méthode de mise en oeuvre habituelles avec pour but premier la diminution importante du poids surfacique, ou grammage.

Ainsi, des feuilles de polymères, comme le polycarbonate (PC), le polyméthacrylate de méthyle (PMMA), le polyfluorure de vinylidène (PVDF), l'éthylène tétrafluoroéthylène (ETFE), l'éthylène chlorotrifluoroéthylène (ECTFE), ou l'éthylène propylène fluoré (FEP), peuvent représenter une alternative au verre. Cependant, lorsque seul le remplacement du verre par une telle feuille mince de polymères est envisagé, la cellule photovoltaïque devient très vulnérable au choc, à la charge mécanique et aux dilatations différentielles.

Une alternative est l'utilisation de matériaux composites à base de fibres de verre en face avant, en remplacement du verre standard. Le gain de poids peut être significativement important en dépit d'une moins bonne transparence.

Le remplacement du verre en face avant des modules photovoltaïques a fait l'objet de plusieurs brevets ou demandes de brevet dans l'art antérieur. On peut ainsi citer à ce titre la demande de brevet FR 2 955 051 A1, la demande de brevet américain US 2005/0178428 A1 ou encore les demandes internationales WO 2008/019229 A2 et WO 2012/140585 A1. D'autres brevets ou demandes de brevet ont décrit l'utilisation de matériaux composites, comme par exemple la demande de brevet européen EP 2 863 443 A1, ou encore les demandes internationales WO 2018/076525 A1, WO 2019/006764 A1 et WO 2019/006765 A1.

Par ailleurs, la demande internationale WO 2019/184242 A1 décrit un assemblage de batterie flexible muni de cellules solaires comprenant des couches renforcées en fibres.

### EXPOSÉ DE L'INVENTION

Il existe ainsi un besoin pour concevoir une solution alternative de module photovoltaïque prévu pour être léger afin de s'adapter à certaines applications, tout en présentant des propriétés mécaniques suffisantes lui permettant d'être résistant aux chocs et à la charge mécanique, et en particulier aux normes IEC 61215 et IEC 61730. Il existe en outre un besoin pour réduire l'épaisseur des composants constitutifs du module photovoltaïque de manière à réduire le poids surfacique, ou grammage, tout en conservant de bonnes propriétés mécaniques.

L'invention a donc pour but de remédier au moins partiellement aux besoins mentionnés précédemment et aux inconvénients relatifs aux réalisations de l'art antérieur.

L'invention a ainsi pour objet, selon l'un de ses aspects, un module photovoltaïque selon la revendication 1.

Ainsi, de façon avantageuse, le principe de l'invention consiste notamment à la fois à remplacer le verre épais standard d'une épaisseur d'environ 3 mm, habituellement utilisé dans un module photovoltaïque classique, par une première couche sous forme de multicouche comprenant un matériau composite polymère/fibres, notamment obtenu à partir d'un préimprégné, et à modifier la face arrière du module photovoltaïque, habituellement formée par un multicouche polymère de type TPT (Tedlar/PET/Tedlar) d'épaisseur de l'ordre de 300 µm, pour prévoir également la présence d'un matériau composite polymère/fibres, notamment obtenu à partir d'un préimprégné.

Par ailleurs, l'ajout d'un film intermédiaire amortissant dans le module photovoltaïque conforme à l'invention permet notamment d'améliorer l'adhésion entre la couche composite et le film de protection. En effet, plus le taux d'imprégnation du composite est faible, plus l'adhésion directe du film de protection est faible compte-tenu de la quantité de résine. Or, cette adhésion peut être problématique pour des taux de résine compris entre 30 et 50 %. De plus, l'ajout d'un film intermédiaire amortissant peut permettre d'améliorer la tenue dans le temps de l'assemblage couche composite/film de protection. Compte-tenu des dilatations thermiques différentielles et des contraintes aux interfaces associées durant la vie du module photovoltaïque, le film intermédiaire amortissant peut permettre d'absorber ces différences de dilatations et d'éviter une délamination prématurée du film de protection en face avant et/ou en face arrière.

Plus généralement également, la structure multicouche formée par la présence d'un film de protection, d'un film intermédiaire amortissant et d'une couche composite peut permettre de filtrer les rayonnements ultraviolets (UV) afin de protéger la couche composite d'un vieillissement prématuré.

Il est en outre à noter que la première couche est formée en plusieurs parties, à savoir qu'elle est multicouche. La deuxième couche peut quant à elle être formée en une ou plusieurs parties, à savoir qu'elle peut être monocouche ou multicouche.

Le terme « transparent » signifie que la première couche formant la face avant du module photovoltaïque est au moins partiellement transparente à la lumière visible, laissant passer au moins environ 80 % de cette lumière.

En particulier, la transparence optique, entre 300 et 1200 nm, de chacune des première et deuxième couches composites peut être supérieure à 80 %. De même, la transparence optique, entre 300 et 1200 nm, du premier film intermédiaire amortissant, et le cas échéant du deuxième film intermédiaire amortissant, peut être supérieure à 90 %. Enfin, la transparence optique, entre 300 et 1200 nm, du premier film de protection, et le cas échéant du deuxième film intermédiaire amortissant, peut être supérieure à 80%.

En outre, par le terme « encapsulant » ou « encapsulé », il faut comprendre que la pluralité de cellules photovoltaïques est disposée dans un volume, par exemple hermétiquement clos vis-à-vis des liquides, au moins en partie formé par au moins deux couches de matériau(x) d'encapsulation, réunies entre elles après lamination pour former l'ensemble encapsulant.

En effet, initialement, c'est-à-dire avant toute opération de lamination, l'ensemble encapsulant est constitué par au moins deux couches de matériau(x) d'encapsulation, dites couches de coeur, entre lesquelles la pluralité de cellules photovoltaïques est encapsulée. Toutefois, pendant l'opération de lamination des couches, les couches de matériau d'encapsulation fondent pour ne former, après l'opération de lamination, qu'une seule couche (ou ensemble) solidifiée dans laquelle sont noyées les cellules photovoltaïques.

Par ailleurs, grâce à l'invention, il peut être possible d'obtenir un nouveau type de module photovoltaïque léger qui, par l'utilisation de matériaux polymères et composites, peut présenter un poids surfacique, ou grammage, inférieur à 4 kg/m². De plus, par l'utilisation d'une face avant et d'une face arrière en composite, notamment préimprégné, polymère/fibres, le module photovoltaïque selon l'invention présente d'excellentes propriétés mécaniques et thermomécaniques.

Le module photovoltaïque selon l'invention peut en outre comporter l'une ou plusieurs des caractéristiques suivantes prises isolément ou suivant toutes combinaisons techniques possibles.

La première couche composite et la deuxième couche composite peuvent présenter chacune un renfort, formé par les fibres, de poids surfacique compris entre 25 et 600 g/m².

En particulier, la première couche composite peut présenter un renfort, formé par les fibres, de poids surfacique compris entre 300 et 600 g/m², notamment strictement supérieur à 300 g/m² et strictement inférieur à 600 g/m². La deuxième couche composite peut présenter un renfort, formé par les fibres, de poids surfacique compris entre 300 et 600 g/m², notamment strictement supérieur à 300 g/m² et strictement inférieur à 600 g/m2.

En outre, le deuxième matériau composite de la deuxième couche composite comporte un taux d'imprégnation de matériau polymère, notamment de résine polymère, compris entre 30 et 70 % en masse, préférentiellement entre 35 et 55 % en masse. Préférentiellement, le taux d'imprégnation peut être compris entre 35 et 50 %, étant strictement inférieur à 50 %. Le taux d'imprégnation peut par exemple être déterminé par un test de perte au feu dont le principe est le suivant : on pèse un échantillon de matériau composite, ensuite on le brûle pour dégrader la partie polymère, et enfin on pèse ce qui reste et qui correspond au renfort en fibres, notamment en fibres de verre. Un tel test est basé sur des normes NF T57-102 et ISO 1172, et plus spécifiquement sur la norme NF T57-518 pour les préimprégnés avec renfort en verre.Le module de Young en traction, mesuré selon la norme EN ISO 527, de chacune des première et deuxième couches composites peut être supérieur à 1 GPa à température ambiante, étant notamment inférieur à 100 GPa.

Par ailleurs, selon une variante de l'invention, la deuxième couche peut en outre comporter :
- un deuxième film intermédiaire amortissant, la deuxième couche composite étant située entre le deuxième film intermédiaire amortissant et l'ensemble encapsulant,
- un deuxième film de protection, le deuxième film intermédiaire amortissant étant situé entre le deuxième film de protection et la deuxième couche composite.

Les première et deuxième couches composites peuvent être identiques. Les éventuels premier et deuxième films intermédiaires amortissant peuvent être identiques. Les éventuels premier et deuxième films de protection peuvent être identiques.

En outre, le premier film intermédiaire amortissant et l'éventuel deuxième film intermédiaire amortissant peuvent présenter un module de Young à 25°C compris entre 2 et 300 MPa.

Le premier film intermédiaire amortissant et l'éventuel deuxième film intermédiaire amortissant peuvent présenter une épaisseur comprise entre 15 et 200 µm, notamment entre 20 et 200 µm, notamment entre 50 et 100 µm.

Par ailleurs, le premier film de protection et l'éventuel deuxième film de protection peuvent présenter une épaisseur comprise entre 15 et 300 µm.

En outre, le premier film de protection et l'éventuel deuxième film de protection peuvent présenter un filtre de coupure UV (« UV cutoff » en anglais) compris entre 320 et 450 nm, ce qui correspond à la longueur d'onde pour laquelle le taux de transmission est égale à 50%. De cette façon, le premier matériau composite et l'éventuel deuxième matériau composite peuvent être protégés du vieillissement aux rayonnements ultraviolets (UV) et éventuellement de l'hydrolyse, ce qui procure au module photovoltaïque une durée de vie allongée.

De plus, le premier matériau composite de la première couche composite et le deuxième matériau composite de la deuxième couche composite peuvent chacun être à base de matériau polymère et de fibres, notamment formé à partir d'un préimprégné, le polymère étant choisi parmi un polyester, un époxy (également appelé une résine époxy), un acrylique (également appelé une résine acrylique), un polyamide et/ou un polyuréthane, entre autres, et les fibres étant choisies parmi les fibres de verre, de carbone, d'aramide et/ou les fibres naturelles, notamment le chanvre, le lin et/ou la soie, entre autres.

En particulier, le premier matériau composite de la première couche composite et le deuxième matériau composite de la deuxième couche composite peuvent être chacun à base de matériau polymère et de fibres, le couple polymère/fibres étant choisi parmi époxy/verre, acrylique/verre et/ou acrylique/lin.

En outre, le premier film de protection et l'éventuel deuxième film de protection peuvent être chacun choisis parmi : le polycarbonate (PC), le polyméthacrylate de méthyle (PMMA), le polytéréphtalate d'éthylène (PET), le polyamide (PA), un polymère fluoré, notamment le polyfluorure de vinyle (PVF) ou le polyfluorure de vinylidène (PVDF), l'éthylène tétrafluoroéthylène (ETFE), l'éthylène chlorotrifluoroéthylène (ECTFE), le polytétrafluoroéthylène (PTFE), le polychlorotrifluoroéthylène (PCTFE), l'éthylène propylène fluoré (FEP) et/ou un film multicouche comprenant un ou plusieurs des polymères précités, entre autres.

Avantageusement, le premier film de protection peut être choisi parmi : le polyfluorure de vinylidène (PVDF), l'éthylène tétrafluoroéthylène (ETFE), l'éthylène chlorotrifluoroéthylène (ECTFE), et/ou un multicouche polyfluorure de vinyle (PVF)/polytéréphtalate d'éthylène (PET)/polyfluorure de vinyle (PVF).

L'ensemble encapsulant peut présenter une épaisseur comprise entre 100 µm et 1200 µm, notamment entre 200 µm et 600 µm.

Par ailleurs, le premier film intermédiaire amortissant, l'éventuel deuxième film intermédiaire amortissant et l'ensemble encapsulant peuvent chacun être formés par au moins une couche comportant au moins un matériau d'encapsulation de type polymère choisi parmi : les copolymères d'acides, les ionomères, le poly(éthylène-acétate de vinyle) (EVA), les acétals de vinyle, tels que les polyvinylbutyrals (PVB), les polyuréthanes, les chlorures de polyvinyle, les polyéthylènes, tels que les polyéthylènes linéaires basse densité, les polyoléfines élastomères de copolymères, les copolymères d'α-oléfines et des α-, β- esters d'acide carboxylique à éthylénique, tels que les copolymères éthylène-acrylate de méthyle et les copolymères éthylène-acrylate de butyle, les élastomères de silicone, et/ou les élastomères à base de polyoléfine thermoplastique réticulée, entre autres.

L'ensemble encapsulant peut être formé par au moins une couche comportant au moins un matériau d'encapsulation de type polymère, et ledit au moins un matériau d'encapsulation de type polymère de l'ensemble encapsulant peut préférentiellement être différent du matériau polymère de la première couche composite et/ou du matériau polymère de la deuxième couche composite.

Préférentiellement, le premier film amortissant et/ou le deuxième film amortissant peuvent chacun être formés par au moins une couche comportant au moins un matériau d'encapsulation de type polymère choisi parmi : les copolymères d'acides, les ionomères et/ou les polyuréthanes. Avantageusement, le premier film amortissant et/ou le deuxième film amortissant peuvent être associés à un premier matériau composite de la première couche composite et/ou un deuxième matériau composite de la deuxième couche composite chacun à base de matériau polymère et de fibres, le couple polymère/fibres étant choisi parmi époxy/verre, acrylique/verre et/ou acrylique/lin. De même, avantageusement, le premier film amortissant et/ou le deuxième film amortissant peuvent être associés à un premier film de protection choisi parmi : le polyfluorure de vinylidène (PVDF), l'éthylène tétrafluoroéthylène (ETFE), l'éthylène chlorotrifluoroéthylène (ECTFE), et/ou un multicouche polyfluorure de vinyle (PVF)/polytéréphtalate d'éthylène (PET)/polyfluorure de vinyle (PVF).

Préférentiellement encore, la première couche comporte une première couche composite comprenant au moins un premier matériau composite à base de résine époxy et de fibres de verre, un premier film intermédiaire amortissant formé par au moins une couche comportant au moins un ionomère, un premier film de protection comprenant de l'éthylène chlorotrifluoroéthylène (ECTFE), la deuxième couche composite comprenant notamment également au moins un deuxième matériau composite à base de résine époxy et de fibres de verre.

En particulier, le premier matériau composite et/ou le deuxième matériau composite peuvent être obtenus à partir d'un préimprégné de type résine époxy, tissu verre-E Satin 8H 300 g/m² imprégné à 37 %.

De plus, les cellules photovoltaïques peuvent être choisies parmi : des cellules photovoltaïques homojonction ou hétérojonction à base de silicium monocristallin (c-Si) et/ou multi-cristallin (mc-Si), et/ou des cellules photovoltaïques de type IBC, et/ou des cellules photovoltaïques comprenant au moins un matériau parmi le silicium amorphe (a-Si), le silicium microcristallin (µC-Si), le tellurure de cadmium (CdTe), le cuivre-indium séléniure (CIS) et le cuivre-indium/gallium diséléniure (CIGS), les perovskites, entre autres.

Par ailleurs, les cellules photovoltaïques peuvent présenter une épaisseur comprise entre 1 et 300 µm, notamment entre 1 et 200 µm, et avantageusement entre 70 µm et 160 µm.

Le module photovoltaïque peut en outre comporter une boîte de jonction, destinée à recevoir le câblage nécessaire à l'exploitation du module photovoltaïque, pouvant être positionnée en face avant ou en face arrière du module, préférentiellement en face avant.

En outre, l'espacement entre deux cellules photovoltaïques voisines, ou encore consécutives ou adjacentes, peut être supérieur ou égal à 1 mm, notamment compris entre 1 et 30 mm, et de préférence égal à 2 mm.

De plus, l'invention a encore pour objet, selon un autre de ses aspects, un procédé de réalisation d'un module photovoltaïque tel que défini précédemment, caractérisé en ce qu'il comporte l'étape de lamination à chaud, à une température comprise entre 130°C et 180°C, notamment de l'ordre de 150°C, et pendant une durée du cycle de lamination d'au moins 5 minutes, notamment comprise entre 10 et 20 minutes, notamment de l'ordre de 10 minutes, des couches constitutives du module photovoltaïque,
la première couche composite et la deuxième couche composite étant obtenues respectivement à partir d'un premier préimprégné et d'un deuxième préimprégné destinés respectivement à former les premier et deuxième matériaux composites.

Le premier préimprégné et le deuxième préimprégné peuvent présenter chacun un renfort, formé par les fibres, de poids surfacique compris entre 25 et 600 g/m², notamment compris entre 300 et 600 g/m², notamment strictement supérieur à 300 g/m² et strictement inférieur à 600 g/m².

Le module photovoltaïque et le procédé de réalisation selon l'invention peuvent comporter l'une quelconque des caractéristiques précédemment énoncées, prises isolément ou selon toutes combinaisons techniquement possibles avec d'autres caractéristiques.

### BRÈVE DESCRIPTION DES DESSINS

L'invention pourra être mieux comprise à la lecture de la description détaillée qui va suivre, d'exemples de mise en oeuvre non limitatifs de celle-ci, ainsi qu'à l'examen des figures, schématiques et partielles, du dessin annexé, sur lequel :
- la figure 1 représente, en coupe, un exemple classique de module photovoltaïque comportant des cellules photovoltaïques cristallines,
- la figure 1A représente une variante de réalisation de l'exemple de la figure 1 dans laquelle les cellules photovoltaïques sont de type IBC,
- la figure 2 représente, en vue éclatée, le module photovoltaïque de la figure 1,
- la figure 3 illustre, en coupe et en vue éclatée, un premier exemple de réalisation d'un module photovoltaïque conforme à l'invention, et
- la figure 4 illustre, en coupe et en vue éclatée, un deuxième exemple de réalisation d'un module photovoltaïque conforme à l'invention.

Dans l'ensemble de ces figures, des références identiques peuvent désigner des éléments identiques ou analogues.

De plus, les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

Les figures 1, 1A et 2 ont déjà été décrites dans la partie relative à l'état de la technique antérieure.

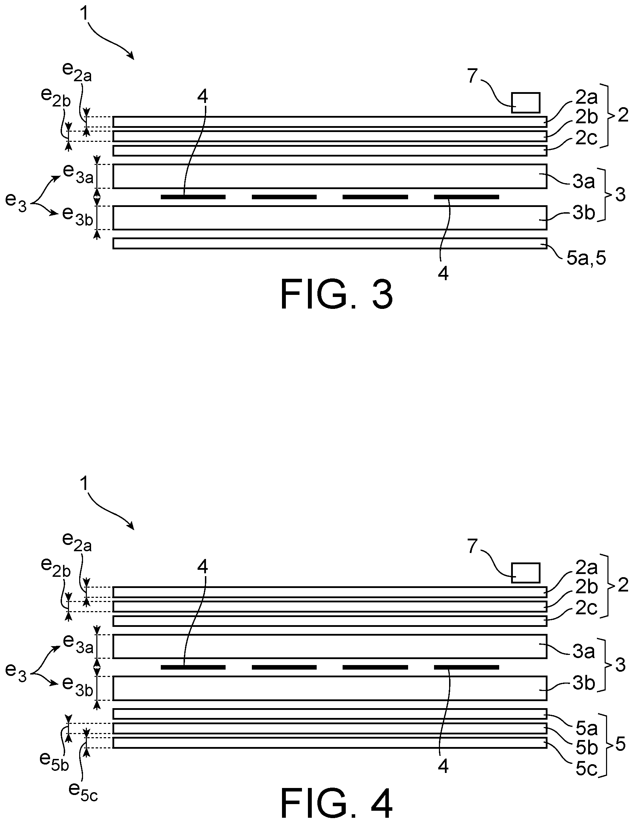

Les figures 3 et 4 illustrent, en coupe et en vue éclatée, deux modes de réalisation distincts de modules photovoltaïques 1 conformes à l'invention.

On considère ici que les cellules photovoltaïques 4, interconnectées par des rubans en cuivre étamé soudés, semblables à ceux représentés aux figures 1, 1A et 2, sont des cellules « cristallines », c'est-à-dire qu'elles comportent du silicium mono ou multicristallin, et qu'elles présentent une épaisseur comprise entre 1 et 250 µm.

Bien entendu, ces choix ne sont nullement limitatifs.

On se réfère tout d'abord à la figure 3 qui illustre, en coupe et en vue éclatée, un premier exemple de réalisation d'un module photovoltaïque 1 conforme à l'invention.

Il est à noter que la figure 3 correspond à une vue éclatée du module photovoltaïque 1 avant l'étape de lamination du procédé selon l'invention. Une fois l'étape de lamination réalisée, assurant un pressage à chaud et sous vide, les différentes couches sont en réalité superposées les unes aux autres.

Le module photovoltaïque 1 comporte ainsi une première couche 2 formant la face avant du module photovoltaïque 1 et destinée à recevoir un flux lumineux, une pluralité de cellules photovoltaïques 4 disposées côte à côte et reliées électriquement entre elles, un ensemble encapsulant 3 la pluralité de cellules photovoltaïques 4, et une deuxième couche 5 formant la face arrière du module photovoltaïque 1.

Il est en outre à noter qu'une boîte de jonction 7 peut être disposée sur la face avant, comme représenté sur la figure 3, ou encore sur la face arrière, du module photovoltaïque 1.

Conformément à l'invention, et de manière commune aux exemples des figures 3 et 4, la première couche 2 est multicouche et comporte : une première couche composite 2c, au contact de l'ensemble encapsulant 3, comprenant un premier matériau composite, formé par un préimprégné, à base de résine polymère et de fibres ; un premier film intermédiaire amortissant 2b ; et un premier film de protection 2a.

De plus, dans cet exemple de la figure 3, la deuxième couche 5 comporte uniquement une deuxième couche composite 5a comprenant un deuxième matériau composite, formé par un préimprégné, à base de résine polymère et de fibres.

Le premier film de protection 2a est par exemple un film d'éthylène chlorotrifluoroéthylène (ECTFE), d'épaisseur e₂ₐ d'environ 25 µm. Le premier film intermédiaire amortissant 2b est par exemple un film de ionomère, par exemple un film de ionomère obtenu à partir de la gamme Jurasol commercialisée par la société Juraplast, d'épaisseur e_{2b} d'environ 100 µm. La première couche composite 2c et la deuxième couche composite 5a sont par exemple identiques et chacune formées par un matériau composite, formé par un préimprégné, à base de résine polymère et de fibres de la gamme HexPly^{®} commercialisée par la société Hexcel.

En outre, l'ensemble encapsulant 3 est par exemple formé à partir d'une base polyéthylène, en particulier à partir de films de la gamme Quentys, notamment BPO 8828, commercialisée par la société Borealis Polyolefine GmbH. Son épaisseur e₃, correspondant à la somme des épaisseurs e₃ₐ et e_{3b} des deux couches constitutives, est par exemple de l'ordre de 1200 µm.

Le module photovoltaïque 1 est obtenu par le biais d'une seule étape de lamination à chaud sous vide à une température d'environ 150°C pendant environ 15 minutes. Le poids surfacique obtenu, sans la présence de la boîte de jonction 7, est de l'ordre de 3,6 kg/m².

Bien entendu, ce premier exemple de réalisation peut être décliné selon diverses variantes en utilisant un ou plusieurs des matériaux mentionnés précédemment pour former la première couche 2 et la deuxième couche 5. Le premier film de protection 2a peut présenter une épaisseur e₂ₐ comprise entre 15 et 300 µm. Le premier film intermédiaire amortissant 2b peut présenter une épaisseur e_{2b} comprise entre 15 et 200 µm. L'ensemble encapsulant 3 peut présenter une épaisseur e₃ comprise entre 100 et 1200 µm. La première couche composite 2c et la deuxième couche composite 5a peuvent chacune présenter un renfort, formé par les fibres, de poids surfacique compris entre 30 et 600 g/m².

Par ailleurs, la figure 4 illustre un deuxième exemple de réalisation conforme à l'invention.

Dans cet exemple, à la différence du premier exemple décrit précédemment en référence à la figure 3, la deuxième couche 5 est aussi multicouche.

Ainsi, la deuxième couche 5 comporte une deuxième couche composite 5a, mais également un deuxième film de protection 5c et un deuxième film intermédiaire amortissant 5b.

Il est à noter que, de manière avantageuse, les première 2 et deuxième 5 couches peuvent être identiques. En particulier, les première 2c et deuxième 5a couches composites peuvent être identiques, les premier 2a et deuxième 5c films de protection peuvent être identiques, et les premier 2b et deuxième 5b films intermédiaires amortissant peuvent être identiques.

Plus particulièrement ici, les premier 2a et deuxième 5c films de protection peuvent par exemple être chacun un film de la gamme dyMat commercialisée par la société Coveme, avec une épaisseur e₂ₐ, e_{5c} de l'ordre de 283 µm. Les premier 2b et deuxième 5b films intermédiaires amortissant peuvent par exemple chacun être un film de ionomère, par exemple un film de ionomère obtenu à partir de la gamme Jurasol commercialisée par la société Juraplast, d'épaisseur e_{2b}, e_{5b} d'environ 200 µm. Les première 2c et deuxième 5a couches composites peuvent chacune être formées par un matériau composite, formé par un préimprégné, à base de résine polymère et de fibres de la gamme HexPly^{®} commercialisée par la société Hexcel.

Le module photovoltaïque 1 est obtenu par le biais d'une seule étape de lamination à chaud sous vide à une température d'environ 150°C pendant environ 15 minutes. Le poids surfacique obtenu, sans la présence de la boîte de jonction 7, est de l'ordre de 2,0 kg/m².

Bien entendu, ce deuxième exemple de réalisation peut être décliné selon diverses variantes en utilisant un ou plusieurs des matériaux mentionnés précédemment pour former la première couche 2 et la deuxième couche 5. Le premier film de protection 2a et le deuxième film de protection 5c peuvent présenter une épaisseur e₂ₐ, e_{5c} comprise entre 15 et 300 µm. Le premier film intermédiaire amortissant 2b et le deuxième film intermédiaire amortissant 5b peuvent présenter une épaisseur e_{2b}, e_{5b} comprise entre 15 et 200 µm. L'ensemble encapsulant 3 peut présenter une épaisseur e₃ comprise entre 100 et 1200 µm. La première couche composite 2c et la deuxième couche composite 5a peuvent chacune présenter un renfort, formé par les fibres, de poids surfacique compris entre 30 et 600 g/m².

Bien entendu, l'invention n'est pas limitée aux exemples de réalisation qui viennent d'être décrits. Diverses modifications peuvent y être apportées par l'homme du métier. L'invention est définie dans les revendications.

## Revendications

1. Module photovoltaïque (1) comportant :
- une première couche (2) transparente formant la face avant du module photovoltaïque (1), destinée à recevoir un flux lumineux,
- une pluralité de cellules photovoltaïques (4) disposées côte à côte et reliées électriquement entre elles,
- un ensemble encapsulant (3) la pluralité de cellules photovoltaïques (4),
- une deuxième couche (5) formant la face arrière du module photovoltaïque (1),
l'ensemble encapsulant (3) et la pluralité de cellules photovoltaïques (4) étant situés entre les première (2) et deuxième (5) couches,
la première couche (2) comportant au moins :
- une première couche composite (2c) comprenant au moins un premier matériau composite à base de matériau polymère et de fibres,
- un premier film intermédiaire amortissant (2b), la première couche composite (2c) étant située entre le premier film intermédiaire amortissant (2b) et l'ensemble encapsulant (3),
- un premier film de protection (2a), le premier film intermédiaire amortissant (2b) étant situé entre le premier film de protection (2a) et la première couche composite (2c),
la deuxième couche (5) comportant au moins :
- une deuxième couche composite (5a) comprenant au moins un deuxième matériau composite à base de matériau polymère et de fibres,
**caractérisé en ce que** le premier matériau composite de la première couche composite (2c) comporte un taux d'imprégnation de matériau polymère compris entre 35 et 50 % en masse et **en ce que** le deuxième matériau composite de la deuxième couche composite (5a) comporte un taux d'imprégnation de matériau polymère compris entre 30 et 70 % en masse.

2. Module selon la revendication 1, **caractérisé en ce que** la première couche composite (2c) et la deuxième couche composite (5a) présentent chacune un renfort, formé par les fibres, de poids surfacique compris entre 25 et 600 g/m², notamment compris entre 300 et 600 g/m².

3. Module selon la revendication 1 ou 2, **caractérisé en ce que** le deuxième matériau composite de la deuxième couche composite (5a) comporte un taux d'imprégnation de matériau polymère compris entre 35 et 55 % en masse.

4. Module selon l'une quelconque des revendications précédentes, **caractérisé en ce que** le module de Young en traction de chacune des première (2c) et deuxième (5a) couches composites est supérieur à 1 GPa à température ambiante, étant notamment inférieur à 100 GPa.

5. Module selon l'une quelconque des revendications précédentes, **caractérisé en ce que** la deuxième couche (5) comporte en outre :
- un deuxième film intermédiaire amortissant (5b), la deuxième couche composite (5a) étant située entre le deuxième film intermédiaire amortissant (5b) et l'ensemble encapsulant (3),
- un deuxième film de protection (5c), le deuxième film intermédiaire amortissant (5b) étant situé entre le deuxième film de protection (5c) et la deuxième couche composite (5a).

6. Module selon la revendication 5, **caractérisé en ce que** les première (2c) et deuxième (5a) couches composites sont identiques, et/ou **en ce que** les premier (2b) et deuxième (5b) films intermédiaires amortissant sont identiques, et/ou **en ce que** les premier (2a) et deuxième (5c) films de protection sont identiques.

7. Module selon la revendication 5 ou 6, **caractérisé en ce que** le premier film intermédiaire amortissant (2b) et le deuxième film intermédiaire amortissant (5b) présentent une épaisseur (e_{2b}, e_{5b}) comprise entre 15 et 200 µm, notamment entre 20 et 200 µm, notamment entre 50 et 100 µm.

8. Module selon l'une quelconque des revendications 5 à 7, **caractérisé en ce que** le premier film de protection (2a) et le deuxième film de protection (5c) présentent une épaisseur (e₂ₐ, e_{5c}) comprise entre 15 et 300 µm.

9. Module selon l'une quelconque des revendications précédentes, **caractérisé en ce que** le premier matériau composite de la première couche composite (2c) et le deuxième matériau composite de la deuxième couche composite (5a) sont chacun à base de matériau polymère et de fibres, le polymère étant choisi parmi un polyester, un époxy, un acrylique, un polyamide et/ou un polyuréthane, et les fibres étant choisies parmi les fibres de verre, de carbone, d'aramide et/ou les fibres naturelles, notamment le chanvre, le lin et/ou la soie.

10. Module selon la revendication 9, **caractérisé en ce que** le premier matériau composite de la première couche composite (2c) et le deuxième matériau composite de la deuxième couche composite (5a) sont chacun à base de matériau polymère et de fibres, le couple polymère/fibres étant choisi parmi époxy/verre, acrylique/verre et/ou acrylique/lin.

11. Module selon l'une quelconque des revendications 5 à 10, **caractérisé en ce que** le premier film de protection (2a) et le deuxième film de protection (5c) sont chacun choisis parmi : le polycarbonate (PC), le polyméthacrylate de méthyle (PMMA), le polytéréphtalate d'éthylène (PET), le polyamide (PA), un polymère fluoré, notamment le polyfluorure de vinyle (PVF) ou le polyfluorure de vinylidène (PVDF), l'éthylène tétrafluoroéthylène (ETFE), l'éthylène chlorotrifluoroéthylène (ECTFE), le polytétrafluoroéthylène (PTFE), le polychlorotrifluoroéthylène (PCTFE), l'éthylène propylène fluoré (FEP) et/ou un film multicouche comprenant un ou plusieurs des polymères précités.

12. Module selon l'une quelconque des revendications 5 à 11, **caractérisé en ce que** le premier film intermédiaire amortissant (2b), le deuxième film intermédiaire amortissant (5b) et l'ensemble encapsulant (3) sont chacun formés par au moins une couche comportant au moins un matériau d'encapsulation de type polymère choisi parmi : les copolymères d'acides, les ionomères, le poly(éthylène-acétate de vinyle) (EVA), les acétals de vinyle, tels que les polyvinylbutyrals (PVB), les polyuréthanes, les chlorures de polyvinyle, les polyéthylènes, tels que les polyéthylènes linéaires basse densité, les polyoléfines élastomères de copolymères, les copolymères d'α-oléfines et des α-, β- esters d'acide carboxylique à éthylénique, tels que les copolymères éthylène-acrylate de méthyle et les copolymères éthylène-acrylate de butyle, les élastomères de silicone, et/ou les élastomères à base de polyoléfine thermoplastique réticulée.

13. Module selon l'une quelconque des revendications précédentes, **caractérisé en ce que** l'ensemble encapsulant (3) est formé par au moins une couche comportant au moins un matériau d'encapsulation de type polymère différent du matériau polymère de la première couche composite (2c) et/ou du matériau polymère de la deuxième couche composite (5a).

14. Module selon l'une quelconque des revendications précédentes, **caractérisé en ce que** la première couche (2) comporte une première couche composite (2c) comprenant au moins un premier matériau composite à base de résine époxy et de fibres de verre, un premier film intermédiaire amortissant (2b) formé par au moins une couche comportant au moins un ionomère, un premier film de protection (2a) comprenant de l'éthylène chlorotrifluoroéthylène (ECTFE), la deuxième couche composite (5a) comprenant notamment également au moins un deuxième matériau composite à base de résine époxy et de fibres de verre.

15. Procédé de réalisation d'un module photovoltaïque (1) selon l'une quelconque des revendications précédentes, **caractérisé en ce qu'**il comporte l'étape de lamination à chaud, à une température comprise entre 130°C et 180°C, notamment de l'ordre de 150°C, et pendant une durée du cycle de lamination d'au moins 5 minutes, notamment comprise entre 5 et 20 minutes, notamment de l'ordre de 10 minutes, des couches constitutives (2, 3, 4, 5) du module photovoltaïque (1), la première couche composite (2c) et la deuxième couche composite (5a) étant obtenues respectivement à partir d'un premier préimprégné et d'un deuxième préimprégné destinés respectivement à former les premier et deuxième matériaux composites.

16. Procédé selon la revendication 15, **caractérisé en ce que** le premier préimprégné et le deuxième préimprégné présentent chacun un renfort, formé par les fibres, de poids surfacique compris entre 25 et 600 g/m², notamment compris entre 300 et 600 g/m².

## Patentansprüche

1. Photovoltaikmodul (1), enthaltend:
- eine erste transparente Schicht (2), die die Vorderseite des Photovoltaikmoduls (1) bildet, die bestimmt ist, um einen Lichtstrom zu empfangen,
- eine Vielzahl von Photovoltaikzellen (4), die nebeneinander angeordnet und elektrisch miteinander verbunden sind,
- eine Anordnung zur Verkapselung (3) der Vielzahl von Photovoltaikzellen (4),
- eine zweite Schicht (5), die die Rückseite des Photovoltaikmoduls (1) bildet, wobei die Verkapselungsanordnung (3) und die Vielzahl von Photovoltaikzellen (4) zwischen der ersten (2) und der zweiten (5) Schicht liegen,
wobei die erste Schicht (2) mindestens enthält:
- eine erste Verbundschicht (2c), die mindestens einen ersten Verbundwerkstoff auf der Basis von Polymerwerkstoff und Fasern umfasst,
- eine erste dämpfende Zwischenfolie (2b), wobei die erste Verbundschicht (2c) zwischen der ersten dämpfenden Zwischenfolie (2b) und der Verkapselungsanordnung (3) liegt,
- eine erste Schutzfolie (2a), wobei die erste dämpfende Zwischenfolie (2b) zwischen der ersten Schutzfolie (2a) und der ersten Verbundschicht (2c) liegt,
wobei die zweite Schicht (5) mindestens enthält:
- eine zweite Verbundschicht (5a), die mindestens einen zweiten Verbundwerkstoff auf der Basis von Polymerwerkstoff und Fasern umfasst,
**dadurch gekennzeichnet, dass** der erste Verbundwerkstoff der ersten Verbundschicht (2c) eine Imprägnierungsrate des Polymerwerkstoffs zwischen 35 und 50 Massenprozent enthält, und dass der zweite Verbundwerkstoff der zweiten Verbundschicht (5a) eine Imprägnierungsrate des Polymerwerkstoffs zwischen 30 und 70 Massenprozent enthält.

2. Modul nach Anspruch 1, **dadurch gekennzeichnet, dass** die erste Verbundschicht (2c) und die zweite Verbundschicht (5a) jeweils eine Verstärkung aufweisen, die aus Fasern mit einem Flächengewicht zwischen 25 und 600 g/m² gebildet ist, insbesondere zwischen 300 und 600 g/m².

3. Modul nach Anspruch 1 oder 2, **dadurch gekennzeichnet, dass** der zweite Verbundwerkstoff der zweiten Verbundschicht (5a) eine Imprägnierungsrate des Polymerwerkstoffs von 35 bis 55 Massenprozent enthält.

4. Modul nach einem der vorhergehenden Ansprüche, **dadurch gekennzeichnet, dass** der Youngscher Modul auf Zug jeder der ersten (2c) und zweiten (5a) Verbundschichten bei Raumtemperatur größer als 1GPa ist, insbesondere kleiner als 100 GPa.

5. Modul nach einem der vorhergehenden Ansprüche, **dadurch gekennzeichnet, dass** die zweite Schicht (5) ferner enthält:
- eine zweite dämpfenden Zwischenfolie (5b), wobei die zweite Verbundschicht (5a) zwischen der zweiten dämpfenden Zwischenfolie (5b) und der Verkapselungsanordnung (3) liegt,
- eine zweite Schutzfolie (5c), wobei die zweite dämpfende Zwischenfolie (5b) zwischen der zweiten Schutzfolie (5c) und der zweiten Verbundschicht (5a) liegt.

6. Modul nach Anspruch 5, **dadurch gekennzeichnet, dass** die erste (2c) und zweite (5a) Verbundschicht identisch sind und/oder dass die erste (2b) und zweite (5b) dämpfende Zwischenfolie identisch sind und/oder dass die erste (2a) und zweite (5c) Schutzfolie identisch sind.

7. Modul nach Anspruch 5 oder 6, **dadurch gekennzeichnet, dass** die erste dämpfende Zwischenfolie (2b) und die zweite dämpfende Zwischenfolie (5b) eine Dicke (e_{2b}, e_{5b}) zwischen 15 und 200 µm aufweisen, insbesondere zwischen 20 und 200 µm, insbesondere zwischen 50 und 100 µm.

8. Modul nach einem der Ansprüche 5 bis 7, **dadurch gekennzeichnet, dass** die erste Schutzfolie (2a) und die zweite Schutzfolie (5c) eine Dicke (e₂ₐ, e_{5c}) zwischen 15 und 300 µm aufweisen.

9. Modul nach einem der vorhergehenden Ansprüche, **dadurch gekennzeichnet, dass** der erste Verbundwerkstoff der ersten Verbundschicht (2c) und der zweite Verbundwerkstoff der zweiten Verbundschicht (5a) jeweils auf der Basis von Polymerwerkstoff und Fasern sind, wobei das Polymer aus Polyester, Epoxidharz, Acryl, Polyamid und/oder Polyurethan ausgewählt ist und die Fasern aus Glas-, Kohlenstoff-, Aramidfasern und/oder Naturfasern ausgewählt sind, insbesondere Hanf, Leinen und/oder Seide.

10. Modul nach Anspruch 9, **dadurch gekennzeichnet, dass** der erste Verbundwerkstoff der ersten Verbundschicht (2c) und der zweite Verbundwerkstoff der zweiten Verbundschicht (5a) jeweils auf der Basis von Polymerwerkstoff und Fasern sind, wobei das Paar Polymer/Faser aus Epoxid/Glas, Acryl/Glas und/oder Acryl/Leinen ausgewählt ist.

11. Modul nach einem der Ansprüche 5 bis 10, **dadurch gekennzeichnet, dass** die erste Schutzfolie (2a) und die zweite Schutzfolie (5c) jeweils ausgewählt sind aus: Polycarbonat (PC), Polymethylmethacrylat (PMMA), Polyethylenterephthalat (PET), Polyamid (PA), einem Fluorpolymer, insbesondere Polyvinylfluorid (PVF) oder Polyvinylidenfluorid (PVDF), Ethylen-Tetrafluorethylen (ETFE), Ethylen-Chlortrifluorethylen (ECTFE), Polytetrafluorethylen (PTFE), Polychlortrifluorethylen (PCTFE), Tetrafluorethylen-Hexafluorpropylen (FEP) und/oder einer mehrschichtige Folie, die eines oder mehrere der vorgenannten Polymere umfasst.

12. Modul nach einem der Ansprüche 5 bis 11, **dadurch gekennzeichnet, dass** die erste dämpfende Zwischenfolie (2b), die zweite dämpfende Zwischenfolie (5b) und die Verkapselungsanordnung (3) jeweils aus mindestens einer Schicht gebildet sind, die mindestens einen Verkapselungswerkstoff vom Typ Polymer enthält, der ausgewählt ist aus: Säurecopolymeren, lonomeren, Poly-EthylenVinylacetat (EVA), Vinylacetalen, wie Polyvinylbutyralen (PVB), Polyurethanen, Polyvinylchloriden, Polyethylenen, wie lineare Polyethylene niedriger Dichte, Polyolefin-Elastomere von Copolymeren, Copolymere von α-Olefinen und von α-, β-Ethylen-Carbonsäureestern, wie Ethylen-Methylacrylat-Copolymere und Ethylen-Butylacrylat-Copolymere, Silikonelastomeren und/oder Elastomere auf der Basis von vernetztem thermoplastischem Polyolefin.

13. Modul nach einem der vorhergehenden Ansprüche, **dadurch gekennzeichnet, dass** die Verkapselungsanordnung (3) aus mindestens einer Schicht gebildet ist, die mindestens einen Verkapselungswerkstoff vom Typ Polymer enthält, der sich vom Polymerwerkstoff der ersten Verbundschicht (2c) und/oder dem Polymerwerkstoff der zweiten Verbundschicht (5a) unterscheidet.

14. Modul nach einem der vorhergehenden Ansprüche, **dadurch gekennzeichnet, dass** die erste Schicht (2) eine erste Verbundschicht (2c) enthält, die mindestens einen ersten Verbundwerkstoff auf der Basis von Epoxidharz und Glasfasern umfasst, eine erste dämpfenden Zwischenfolie (2b), die aus mindestens einer Schicht gebildet ist, die mindestens ein lonomer enthält, und eine erste Schutzfolie (2a), die Ethylen-Chlortrifluorethylen (ECTFE) umfasst, wobei die zweite Verbundschicht (5a) insbesondere auch mindestens einen zweiten Verbundwerkstoff auf der Basis von Epoxidharz und Glasfasern umfasst.

15. Verfahren zur Herstellung eines Photovoltaikmoduls (1) nach einem der vorhergehenden Ansprüche, **dadurch gekennzeichnet, dass** es den Schritt des Warmwalzens bei einer Temperatur zwischen 130 °C und 180 °C enthält, insbesondere in der Größenordnung von 150 °C, und während einer Dauer des Walzzyklus von mindestens 5 Minuten, insbesondere zwischen 5 und 20 Minuten, insbesondere in der Größenordnung von 10 Minuten, der Teilschichten (2, 3, 4, 5) des Photovoltaikmoduls (1), wobei die erste Verbundschicht (2c) und die zweite Verbundschicht (5a) jeweils aus einem ersten Prepreg und einem zweiten Prepreg erhalten werden, die jeweils zur Bildung des ersten und zweiten Verbundwerkstoffs bestimmt sind.

16. Verfahren nach Anspruch 15, **dadurch gekennzeichnet, dass** das erste Prepreg und das zweite Prepreg jeweils eine Verstärkung aufweisen, die aus Fasern mit einem Flächengewicht zwischen 25 und 600 g/m² gebildet ist, insbesondere zwischen 300 und 600 g/m².

## Claims

1. A photovoltaic module (1) comprising:
- a first transparent layer (2) forming the front face of the photovoltaic module (1), intended to receive a light flux,
- a plurality of photovoltaic cells (4) which are disposed side by side and electrically connected to each other,
- an assembly encapsulating (3) the plurality of photovoltaic cells (4);
- a second layer (5) forming the rear face of the photovoltaic module (1),
the encapsulating assembly (3) and the plurality of photovoltaic cells (4) being located between the first (2) and second (5) layers,
the first layer (2) including at least:
- one first composite layer (2c) comprising at least one first composite material based on polymer material and fibres,
- one first damping intermediate film (2b), the first composite layer (2c) being located between the first damping intermediate film (2b) and the encapsulating assembly (3),
- one first protective film (2a), the first damping intermediate film (2b) being located between the first protective film (2a) and the first composite layer (2c),
the second layer (5) including at least:
- one second composite layer (5a) comprising at least one second composite material based on polymer material and fibres,
**characterised in that** the first composite material of the first composite layer (2c) includes a polymer material impregnation rate comprised between 35 and 50% by weight and **in that** the second composite material of the second composite layer (5a) includes a polymer material impregnation rate comprised between 30 and 70% by weight.

2. The module according to claim 1, **characterised in that** the first composite layer (2c) and the second composite layer (5a) each have a reinforcement, formed by the fibres, of surface weight comprised between 25 and 600 g/m², in particular comprised between 300 and 600 g/m².

3. The module according to claim 1 or 2, **characterised in that** the second composite material of the second composite layer (5a) includes a polymer material impregnation rate comprised between 35 and 55% by weight.

4. The module according to any one of the preceding claims, **characterised in that** the tensile Young's modulus of each of the first (2c) and second (5a) composite layers is greater than 1 GPa at ambient temperature, being in particular less than 100 GPa.

5. The module according to any one of the preceding claims, **characterised in that** the second layer (5) further includes:
- a second damping intermediate film (5b), the second composite layer (5a) being located between the second damping intermediate film (5b) and the encapsulating assembly (3),
- a second protective film (5c), the second damping intermediate film (5b) being located between the second protective film (5c) and the second composite layer (5a).

6. The module according to claim 5, **characterised in that** the first (2c) and second (5a) composite layers are identical, and/or **in that** the first (2b) and second (5b) damping intermediate films are identical, and/or **in that** the first (2a) and second (5c) protective films are identical.

7. The module according to claim 5 or 6, **characterised in that** the first damping intermediate film (2b) and the second damping intermediate film (5b) have a thickness (e_{2b}, e_{5b}) comprised between 15 and 200 µm, in particular between 20 and 200 µm, in particular between 50 and 100 µm.

8. The module according to any one of claims 5 to 7, **characterised in that** the first protective film (2a) and the second protective film (5c) have a thickness (e₂ₐ, e_{5c}) comprised between 15 and 300 µm.

9. The module according to any one of the preceding claims, **characterised in that** the first composite material of the first composite layer (2c) and the second composite material of the second composite layer (5a) are each based on polymer material and fibres, the polymer being selected from a polyester, an epoxy, an acrylic, a polyamide and/or a polyurethane, and the fibres being selected from glass, carbon, aramid fibres and/or natural fibres, in particular hemp, flax and/or silk.

10. The module according to claim 9, **characterised in that** the first composite material of the first composite layer (2c) and the second composite material of the second composite layer (5a) are each based on polymer material and fibres, the polymer/fibres pair being selected from epoxy/glass, acrylic/glass and/or acrylic/flax.

11. The module according to any one of claims 5 to 10, **characterised in that** the first protective film (2a) and the second protective film (5c) are each selected from: polycarbonate (PC), polymethyl methacrylate (PMMA), polyethylene terephthalate (PET), polyamide (PA), a fluorinated polymer, in particular polyvinyl fluoride (PVF) or polyvinylidene fluoride (PVDF), ethylene tetrafluoroethylene (ETFE), ethylene chlorotrifluoroethylene (ECTFE), polytetrafluoroethylene (PTFE), polychlorotrifluoroethylene (PCTFE), fluorinated ethylene propylene (FEP) and/or a multilayer film comprising one or more of the aforementioned polymers.

12. The module according to any one of claims 5 to 11, **characterised in that** the first damping intermediate film (2b), the second damping intermediate film (5b) and the encapsulating assembly (3) are each formed by at least one layer including at least one polymer-type encapsulation material selected from: acid copolymers, ionomers, poly(ethylene-vinyl acetate) (EVA), vinyl acetals, such as polyvinyl butyrals (PVB), polyurethanes, polyvinyl chlorides, polyethylenes, such as linear low density polyethylenes, elastomeric polyolefins of copolymers, copolymers of α-olefins and α-, β-carboxylic to ethylene acid esters, such as ethylene-methyl acrylate copolymers and ethylene-butyl acrylate copolymers, silicone elastomers, and/or elastomers based on crosslinked thermoplastic polyolefin.

13. The module according to any one of the preceding claims, **characterised in that** the encapsulating assembly (3) is formed by at least one layer including at least one polymer type encapsulation material which is different from the polymer material of the first composite layer (2c) and/or the polymer material of the second composite layer (5a).

14. The module according to any one of the preceding claims, **characterised in that** the first layer (2) includes a first composite layer (2c) comprising at least one first composite material based on epoxy resin and glass fibres, a first damping intermediate film (2b) formed by at least one layer including at least one ionomer, a first protective film (2a) comprising ethylene chlorotrifluoroethylene (ECTFE), the second composite layer (5a) also including in particular at least one second composite material based on epoxy resin and glass fibre.

15. A method for producing a photovoltaic module (1) according to any one of the preceding claims, **characterised in that** it includes the step of hot lamination, at a temperature comprised between 130°C and 180°C, in particular in the range of 150°C, and for a duration of the lamination cycle of at least 5 minutes, in particular comprised between 5 and 20 minutes, in particular in the range of 10 minutes, of the constituent layers (2, 3, 4, 5) of the photovoltaic module (1), the first composite layer (2c) and the second composite layer (5a) being obtained respectively from a first prepreg and a second prepreg intended respectively to form the first and second composite materials.

16. The method according to claim 15, **characterised in that** the first prepreg and the second prepreg each have a reinforcement, formed by the fibres, of surface weight comprised between 25 and 600 g/m², in particular comprised between 300 and 600 g/m².
